# FASCICULE DE BREVET EUROPEEN

(11) **EP 2 659 750 B1**
(45) Date de publication et mention de la délivrance du brevet: **07.09.2016**
(21) Numéro de dépôt: 11819101.4
(22) Date de dépôt: 22.12.2011
(51) Int. Cl.: H05K 3/00, H05K 7/14

(54) **ENSEMBLE D'UNE PLAQUE DE CIRCUIT ÉLECTRONIQUE ET D'UN SUPPORT DE LADITE PLAQUE AINSI QU'UN PROCÉDÉ D'ASSEMBLAGE D'UN TEL ENSEMBLE**
ANORDNUNG MIT EINEM WAFER MIT ELEKTRONISCHER SCHALTUNG UND EINEM WAFERSUBSTRAT SOWIE MONTAGEVERFAHREN DAFÜR
ASSEMBLY COMPRISING AN ELECTRONIC CIRCUIT WAFER AND A MEMBER SUPPORTING SAID WAFER, AND A METHOD FOR ASSEMBLING SAME

(30) Priorité: 30.12.2010 FR 1061360
(43) Date de publication de la demande: 06.11.2013
(73) Titulaire: Valeo Systèmes de Contrôle Moteur, 95800 Cergy (FR)
(72) Inventeur: MORENO, Jean-Yves, 60110 Meru (FR)
(86) Numéro de dépôt international: PCT/FR2011/053167
(87) Numéro de publication internationale: WO 2012/089971

(56) Documents cités:
- JP-A- 2010 258 075
- US-A1- 2010 237 493
- US-B1- 7 658 470

## Description

La présente invention concerne un ensemble d'une plaque de circuit électronique et d'un support de ladite plaque ainsi qu'un procédé d'assemblage d'un tel ensemble.

Ledit ensemble trouvera ses applications, notamment, en tant que boîtier électronique destiné à être embarqué, par exemple, dans un véhicule automobile.

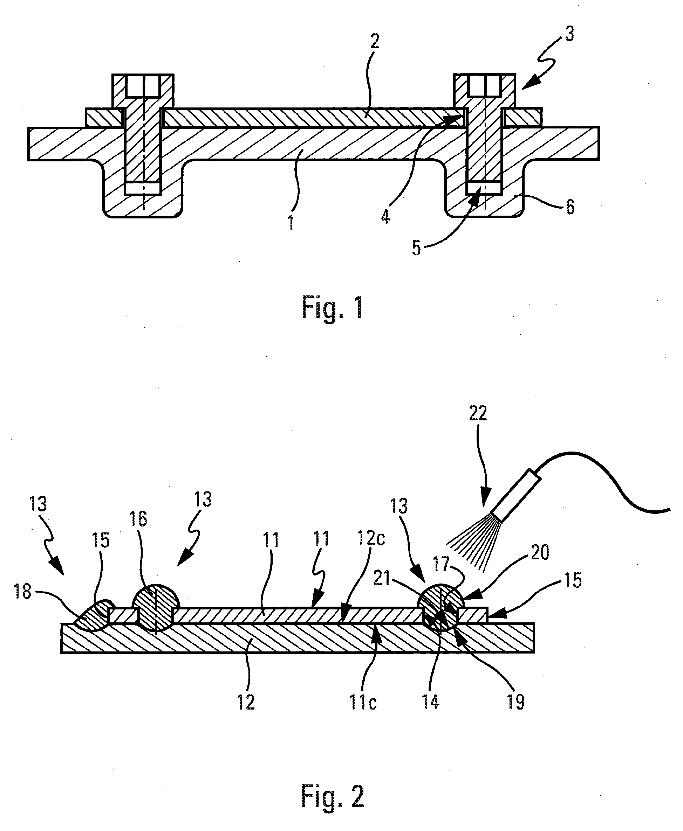

De tels boitiers sont soumis à des chocs thermiques et/ou à des vibrations. Pour résister à ceux-ci, il est connu de fixer leur carte électronique 2 sur le carter 1 du boîtier à l'aide de vis 3 traversant un orifice 4 prévu dans la carte 2 pour venir se fixer dans un trou 5 prévu dans le carter 1, comme illustré à la figure 1.

Pour assurer une bonne tenue au serrage, il faut que le carter 1 soit muni de trous 5 calibrés présentant une profondeur adéquate afin d'assurer qu'un certains nombres de filets de la vis 3 soit en prise dans la matière du support. Les trous calibrés 5 sont réalisés au niveau de bossages 6, formés par des surépaisseurs de matière du carter 1.

Les vis de maintien 3 sont des vis auto taraudeuses ayant subi un traitement de zingage pour éviter les problèmes d'oxydation.

Une telle solution présente de nombreuses difficultés. Elle nécessite l'utilisation de carter et de vis de forme et/ou de structure complexes. En outre, lorsque la vis rentre en contact avec la carte électronique, elle lui transmet une force de torsion qui entraîne une déformation de la carte, ce qui peut être la source, entre autres, d'une fragilisation de la liaison entre la carte et les composants qu'elle supporte et/ou d'une perte de transfert thermique entre la plaque et son support. Il est également à noter que la taille des trous pour le passage des vis et les surfaces à laisser libre sur la plaque pour la prise d'appui des têtes de vis limitent la place disponible pour les composants et rend le routage plus complexe.

L'invention se propose de résoudre ces problèmes et porte sur un ensemble d'une plaque de circuit électronique et d'un support de ladite plaque, ledit ensemble comprenant en outre un matériau rapporté permettant de réaliser un accrochage par collage de ladite plaque sur ledit support.

On peut ainsi supprimer l'utilisation de vis et les inconvénients qu'elles génèrent. On pourra en particulier améliorer la distribution des composants et faciliter le routage. On pourra aussi éviter de détériorer la fixation des composants. On pourra encore simplifier la réalisation du support.

JP 2010-258075 A divulgue un ensemble d'une plaque de circuit électronique et d'un support de ladite plaque, ledit ensemble comprenant en outre un matériau distribué sous la forme de points de collage selon le préambule de la revendication 1.

Selon différents mode de réalisation :
- ladite plaque est munie d'au moins un orifice, dit de fixation, traversant, ledit matériau passant à travers ledit orifice de fixation de façon à venir en contact dudit support et de ladite plaque,
- ladite plaque est munie de composants et/ou de pistes reliant lesdits composants, prévus à proximité immédiate du ou desdits orifices de fixation,
- ladite plaque est munie d'un bord et ledit matériau est localisé contre ledit bord de façon à venir en contact dudit support et de ladite plaque,
- le matériau est distribué sous la forme de points de collage,
- ladite plaque et ledit support présentent deux surfaces en regard, au contact l'une de l'autre, dites surfaces de contact,
- le ou lesdits points de collage présentent une surface distale en contact avec la surface de contact du support,
- le ou lesdits points de collage présentent une tête prenant appui sur une face de la plaque opposée à la face de contact de ladite plaque,
- la face de contact du support présente des empreintes réalisées en creux au droit des orifices de fixation,
- lesdites empreintes présentent une rugosité plus importante que celle du reste de la surface de contact du support,
- lesdites empreintes présentent un diamètre inférieur ou égal au diamètre des orifices de fixation,
- ladite plaque est en outre munie de trous de centrage et/ou le support est muni de pions de centrage, par exemple coopérant ave lesdits trous de centrage.

L'invention concerne également un procédé d'assemblage d'une plaque de circuit électronique et d'un support de ladite plaque, procédé dans lequel on colle ladite plaque sur ledit support grâce à un matériau rapporté.

Selon différents modes de réalisation :
- on positionne ledit matériau sous la forme de points de collage,
- ledit matériau est une résine photo activable et on effectue un éclairage desdits points pour faire durcir la résine.

L'invention sera mieux comprise à la lumière de la description suivante qui n'est donnée qu'à titre indicatif et qui n'a pas pour but de la limiter, accompagnée des dessins joints parmi lesquels :
- la figure 1, déjà commentée, illustre de façon schématique en vue de coupe un ensemble d'une plaque de circuit électronique et d'un support de ladite plaque, selon l'état de l'art
- la figure 2 illustre de façon schématique en vue de coupe un exemple de réalisation d'un ensemble d'une plaque de circuit électronique et d'un support de ladite plaque, conforme à l'invention.

Comme illustré à la figure 2, l'invention concerne un ensemble d'une plaque de circuit électronique 11 et d'un support 12 de ladite plaque 11.

Ladite plaque, ou carte, 11 est constituée, par exemple, d'un circuit imprimé et présentent des composants électroniques et/ou des circuits reliant lesdits composants, non représentés. Il pourra s'agir de circuits imprimés multicouches, par exemple de type FR4. Il pourra aussi s'agir, entre autres, de circuits imprimés du type présentant un substrat métallique isolé ou SMI.

Ledit support est constitué, par exemple, d'un carter de boîtier électronique. Il pourra être de type métallique et/ou plastique.

Ladite plaque 11 et ledit support 12 présentent, notamment, deux surfaces en regard 11c, 12c, au contact l'une de l'autre, dites surfaces de contact. Ladite plaque 11 est prévue, par exemple, au-dessus dudit support 12, dans un plan différent de celui-ci. Le support 12 présente une forme sensiblement plane, sans bossage, au moins au niveau de la zone où la plaque 11 est positionnée.

Ledit ensemble comprend en outre un matériau rapporté 13 permettant de réaliser un accrochage par collage de ladite plaque 11 sur ledit support 12. On peut ainsi éviter l'utilisation de vis et leurs nombreux inconvénients.

Ledit matériau 13 pourra être constitué d'une colle. On entend par là tout matériau susceptible, en passant d'un état pâteux à un état durci, d'adhérer avec les objets avec lesquels il est en contact et réaliser de la sorte une fonction d'accrochage entre lesdits objets. Il s'agit, par exemple, d'une résine mono-composant, notamment du type photo activable, moyenne ou basse viscosité.

Ladite plaque 11 est munie, par exemple, d'au moins un orifice traversant 14, dit orifice de fixation, et ledit matériau 13 passe à travers ledit orifice de fixation 14 de façon à venir en contact dudit support 12 et de ladite plaque 11. Ledit matériau 13 joue ainsi le rôle de rivet chimique.

Comme il n'est plus nécessaire de dégager de la place pour les têtes de vis, les composants et/ou les pistes reliant lesdits composants pourront être prévus à proximité immédiate desdits orifices de fixation 14.

Ces derniers sont, par exemple, de forme circulaire et présente un diamètre inférieur à 4 mm.

Ledit matériau 13 pourra aussi être localisé contre un bord 15 de la plaque 12 de façon à venir en contact dudit support 12 et de ladite plaque 11.

Ledit matériau 13 est distribué, par exemple, sous la forme de points de collage 16, 17, 18. Autrement dit, des points de collage 16, 17, 18 sont prévus au niveau desdits orifices de fixation 14 et/ou des bords 15 de la plaque 11.

Le ou lesdits points de collage pourront présenter une surface distale 19 en contact avec la surface de contact 12c du support 12.

Ils pourront aussi présenter une tête 20 prenant appui sur une face 11 r de la plaque 11 portant les composants, c'est-à-dire, ici, la face opposée à la face de contact 11 c de ladite plaque 11, en particulier en ce qui concerne les points de collage 16, 17 prévus au niveau des orifices de fixation 14. Dans un tel cas, ladite tête 20 présente, notamment, une forme arrondie avec un diamètre juste supérieur à celui de l'orifice de fixation 14.

La face de contact 12c du support présente, par exemple, des empreintes 21, réalisées en creux, au droit des orifices de fixation 14.

Lesdites empreintes 21 présentent, par exemple, une forme de calotte sphérique. Elles coopèrent avec la surface distale 19 des points de collage 16, 17.

Lesdites empreintes 21 pourront présenter une rugosité plus importante que celle du reste de la surface de contact 12c du support 12 afin de faciliter l'accrochage Elles présentent, par exemple, un diamètre inférieur ou égal au diamètre des orifices de fixation 14, en particulier en cas d'utilisation de résines photo activables, l'intérêt d'une telle disposition étant alors d'éviter de créer des zones non atteignables pour les rayons UV chargées de faire réagir la résine, selon le mode de mise en oeuvre du procédé conforme à l'invention évoqué plus bas.

Ladite plaque 11 pourra en outre être munie de trous de centrage destiné à coopérer avec des pions de centrage issus du support 12, non représentés.

L'invention concerne encore un procédé d'assemblage d'une plaque de circuit électronique 11 et d'un support 12 de ladite plaque 11. Ledit procédé visera, notamment, la réalisation d'ensembles tels qu'évoqués plus haut.

Selon le procédé conforme à l'invention, on colle ladite plaque 11 sur ledit support 12 grâce à un matériau rapporté 13. On peut ainsi simplifier l'automatisation des lignes de fabrication, notamment en supprimant les opérations d'alimentation, positionnement et vissage des vis, selon les procédés de l'état de l'art, opérations complexes à réaliser avec des robots.

Comme évoqué plus haut, on pourra positionner ledit matériau 13 sous la forme de points de collage 16, 17, 18, notamment dans le cas d'un matériau 13 constitué d'une résine photo activable. On effectue alors un éclairage desdits points 16, 17, 18 pour faire durcir le matériau 13.

A titre d'exemple, l'assemblage de la plaque 11 et de son support 12 est réalisé de la façon suivante.

On positionne la plaque 11 sur le support 12, notamment à l'aide des pions de centrages.

Par la suite, pourra maintenir la plaque 11 et le support 12 l'un contre l'autre à l'aide d'outil de serrage, non représentés.

On coule la résine photo activable 13 sous la forme des points de collage 16, 17, 18 dans les trous de fixation 14 et/ou au bord de plaque 11. Cette opération peut être réalisée, par exemple, à l'aide d'un distributeur à pression.

De préférence, on s'assurera que la résine a bien rempli les orifices de fixation 14 et déborde légèrement sur la plaque 11.

On réalise alors le traitement de la résine dans le but de réaliser sa polymérisation, notamment, par éclairage des points de collage 16, 17, 18 à la lumière visible, par exemple avec une lumière présentant une gamme de longueurs d'onde situées entre 400 et 500 nm. Cette opération peut être réalisée, par exemple, à l'aide d'une lampe 22 à fibres optiques.

On adaptera la puissance de la lampe, la distance entre la lampe et la résine et le temps d'éclairage à l'épaisseur de résine. A titre d'exemple, il s'agit de temps d'éclairage de l'ordre de la dizaine de seconde.

Pour finir, on pourra desserrer l'outil de serrage, après le temps d'éclairage choisi. On laissera la polymérisation s'achever par la suite, notamment dans un délai de l'ordre de la journée.

## Revendications

1. Ensemble d'une plaque (11) de circuit électronique et d'un support (12) de ladite plaque, ladite plaque (11) et ledit support (12) présentant deux surfaces en regard (11c, 12c), au contact l'une de l'autre, dites surfaces de contact, et ledit ensemble comprenant en outre un matériau rapporté (13) distribué sous la forme de points de collage (16, 17, 18) et permettant de réaliser un accrochage par collage de ladite plaque (11) sur ledit support (12), **caractérisé en ce que**
ladite plaque est munie d'au moins un orifice (14) traversant, dit de fixation, et la face de contact (12c) du support (12) présente des empreintes (21) réalisées en creux au droit des orifices de fixation (14), ledit matériau passant à travers ledit orifice de fixation (14) de façon à venir en contact dudit support (12) et de ladite plaque (11).

2. Ensemble selon la revendication 1 dans lequel ladite plaque (11) est munie de composants et/ou de pistes reliant lesdits composants, prévus à proximité immédiate du ou desdits orifices de fixation (14).

3. Ensemble selon l'une quelconque des revendications 1 ou 2 dans lequel ladite plaque (11) est munie d'un bord (15) et ledit matériau est localisé contre ledit bord (15) de façon à venir en contact dudit support (12) et de ladite plaque (11).

4. Ensemble selon l'une des revendications 1 à 3 dans lequel le ou lesdits points de collage présentent une surface distale (19) en contact avec la surface de contact (12c) du support (12).

5. Ensemble selon l'une quelconque des revendications 1 à 4 dans lequel le ou lesdits points de collage présentent une tête (20) prenant appui sur une face (11r) de la plaque (11) opposée à la face de contact (11c) de ladite plaque (11).

6. Ensemble selon l'une des revendications 1 à 5 dans lequel lesdites empreintes (21) présentent une rugosité plus importante que celle du reste de la surface de contact (12c) du support.

7. Ensemble selon l'une quelconque des revendications 1 à 6 dans lequel lesdites empreintes (21) présentent un diamètre inférieur ou égal au diamètre des orifices de fixation (14).

8. Ensemble selon l'une quelconque des revendications 1 à 7 dans lequel ladite plaque (11) est en outre munie de trous de centrage et/ou le support (12) est muni de pions de centrage.

9. Procédé d'assemblage d'une plaque (11) de circuit électronique et d'un support (12) de ladite plaque (11), procédé dans lequel on positionne la plaque (11) sur le support (12), la surface de contact (12c) du support (12) présentant des empreintes en creux au droit des orifices (14) de fixation de la plaque (11) ; on colle ladite plaque (11) sur ledit support (12) grâce à un matériau rapporté (13).

10. Procédé selon la revendication 9 dans lequel on positionne ledit matériau (13) sous la forme de points de collage (16, 17, 18).

11. Procédé selon la revendication 10 dans lequel ledit matériau est une résine photo activable et on effectue un éclairage desdits points (16, 17, 18) pour faire durcir la résine (13).

## Patentansprüche

1. Anordnung aus einer Platte (11) einer elektronischen Schaltung und einem Träger (12) der Platte, wobei die Platte (11) und der Träger (12) zwei einander gegenüber und in gegenseitigem Kontakt befindliche Oberflächen (11c, 12c), die Kontaktoberflächen genannt werden, aufweisen und wobei die Anordnung außerdem ein aufgetragenes Material (13) umfasst, das in Form von Klebepunkten (16, 17, 18) verteilt ist und ermöglicht, eine Verankerung durch Kleben der Platte (11) an dem Träger (12) zu verwirklichen, **dadurch gekennzeichnet, dass**
die Platte mit wenigstens einer Durchgangsöffnung (14), die Befestigungsöffnung genannt wird, versehen ist und die Kontaktfläche (12c) des Trägers (12) vertieft verwirklichte Eindrücke (21) am Ort der Befestigungsöffnungen (14) aufweist, wobei das Material durch die Befestigungsöffnung (14) verläuft, derart, dass es mit dem Träger (12) und mit der Platte (11) in Kontakt gelangt.

2. Anordnung nach Anspruch 1, wobei die Platte (11) mit Komponenten und/oder Bahnen, die die Komponenten verbinden, versehen ist, die in direkter Nähe der einen oder der mehreren Befestigungsöffnungen (14) vorgesehen sind.

3. Anordnung nach einem der Ansprüche 1 oder 2, wobei die Platte (11) mit einem Rand (15) versehen ist und das Material sich an dem Rand (15) befindet, derart, dass es mit dem Träger (12) und der Platte (11) in Kontakt gelangt.

4. Anordnung nach einem der Ansprüche 1 bis 3, wobei der oder die Klebepunkte eine distale Oberfläche (19) in Kontakt mit der Kontaktoberfläche (12c) des Trägers (12) aufweisen.

5. Anordnung nach einem der Ansprüche 1 bis 4, wobei der oder die Klebepunkte einen Kopf (20) aufweisen, der sich auf einer Fläche (11r) der Platte (11) gegenüber der Kontaktfläche (11c) der Platte (11) abstützt.

6. Anordnung nach einem der Ansprüche 1 bis 5, wobei die Eindrücke (21) eine größere Rauigkeit als der Rest der Kontaktoberfläche (12c) des Trägers aufweisen.

7. Anordnung nach einem der Ansprüche 1 bis 6, wobei die Eindrücke (21) einen Durchmesser aufweisen, der kleiner oder gleich dem Durchmesser der Befestigungsöffnungen (14) ist.

8. Anordnung nach einem der Ansprüche 1 bis 7, wobei die Platte (11) außerdem mit Zentrierungslöchern versehen ist und/oder der Träger (12) mit Zentrierungserhebungen versehen ist.

9. Verfahren zum Zusammenfügen einer Platte (11) einer elektronischen Schaltung und eines Trägers (12) der Platte (11), wobei in dem Verfahren die Platte (11) auf dem Träger (12) positioniert wird, wobei die Kontaktoberfläche (12c) des Trägers (12) hohle Eindrücke am Ort von Befestigungsöffnungen (14) der Platte (11) aufweist; und die Platte (11) an den Träger (12) mittels eines aufgetragenen Materials (13) geklebt wird.

10. Verfahren nach Anspruch 9, wobei das Material (13) in Form von Klebepunkten (16, 17, 18) positioniert wird.

11. Verfahren nach Anspruch 10, wobei das Material ein photoaktivierbares Harz ist und die Punkte (16, 17, 18) beleuchtet werden, um das Harz (13) zu härten.

## Claims

1. Assembly of an electronic circuit board (11) and a carrier (12) of said board, said board (11) and said carrier (12) having two facing surfaces (11c, 12c), referred to as contact surfaces, that make contact with one another, and said assembly furthermore comprising a distributed added material (13) taking the form of adhesive bonding spots (16, 17, 18) and allowing said board (11) and said carrier (12) to be fastened together by adhesive bonding, **characterized in that**
said board is equipped with at least one through-orifice (14) called a fastening orifice, and the contact face (12c) of the carrier (12) has recessed imprints (21) plumb with the fastening orifices (14), said material passing through said fastening orifice (14) so as to make contact with said carrier (12) and said board (11).

2. Assembly according to Claim 1, wherein said board (11) is equipped with components and/or tracks connecting said components, provided in immediate proximity to said one or more fastening orifices (14).

3. Assembly according to either one of Claims 1 and 2, wherein said board (11) is equipped with an edge (15) and said material is located against said edge (15) so as to make contact with said carrier (12) and said board (11).

4. Assembly according to one of Claims 1 to 3, wherein the one or more bonding spots have a distal surface (19) making contact with the contact surface (12c) of the carrier (12).

5. Assembly according to any one of Claims 1 to 4, wherein said one or more bonding spots have a head (20) bearing against a face (11r) of the board (11) opposite the contact face (11c) of said board (11).

6. Assembly according to one of Claims 1 to 5, wherein said imprints (21) have a higher roughness than that of the rest of the contact surface (12c) of the carrier.

7. Assembly according to any one of Claims 1 to 6, wherein said imprints (21) have a diameter smaller than or equal to the diameter of the fastening orifices (14).

8. Assembly according to any one of Claims 1 to 7, wherein said board (11) is furthermore equipped with centring holes and/or the carrier (12) is equipped with centring pins.

9. Process for assembling an electronic circuit board (11) and a carrier (12) of said board (11), process wherein the board (11) is positioned on the carrier (12), the contact surface (12c) of the carrier (12) having recessed imprints plumb with fastening orifices (14) of the board (11); and said board (11) is adhesively bonded to said carrier (12) by virtue of an added material (13).

10. Process according to Claim 9, wherein said material (13) is positioned in the form of bonding spots (16, 17, 18).

11. Process according to Claim 10, wherein said material is an activatable photoresist and said spots (16, 17, 18) are illuminated in order to set the resist (13).
